# EUROPÄISCHE PATENTANMELDUNG

(11) **EP 1 006 770 A1**
(43) Veröffentlichungstag der Anmeldung: **07.06.2000**
(21) Anmeldenummer: 98811199.3
(22) Anmeldetag: 03.12.1998
(51) Int. Cl.: H05K 13/04, H05K 13/08

(54) **Verfahren zur Bestückung eines Werkstückes, Bestückungsautomat, sowie Zuführeinheit für einen solchen Bestückungsautomaten**

(71) Anmelder: ESEC Management SA, 6330 Cham (CH); ZEVATECH, INCORPORATED, Morrisville, NC 27560 (US)
(72) Erfinder: Scherer, Jakob Robert, Morrisville, NC 27560 (US)
(74) Vertreter: Fernandez, Isabel

(57) **Zusammenfassung**

Alle in einer bestimmten Arbeitsumgebung verwendeten Zuführeinheiten (1) für einen Bestückungsautomaten (2) weisen je einen eigenen, von den anderen Zuführeinheiten (1) verschiedenen Code (7) auf, der von einer am Pick-up-Kopf (6) des Bestückungsautomaten (2) ohnehin vorhandenen Kamera (8) lesbar ist. Jeweils dann, wenn eine der Zuführeinheiten auf einem sogenannten Rüstplatz (9) mit Bauteilen beladen wird, erfasst eine am Rüstplatz (9) vorhandene Kamera (11) automatisch den Code (7) der Zuführeinheit (1). Der erfasste Code (7) wird zusammen mit Daten, die die geladenen Bauteile identifizieren, in einer Datenbank (12) gespeichert. Nach dem Einsetzen der Zuführeinheit (1) in den Bestückungsautomaten (2) erfasst der Bestückungsautomat (2) mit der Kamera (8) seines Pick-up-Kopfes (6) den Code (7) der Zuführeinheit (1) und entnimmt der Datenbank (12) anhand des gelesenen Codes (7) die Daten, die die Bauteile der zugeführten Zuführeinheit (1) identifizieren.

## Beschreibung

Die Erfindung betrifft ein Verfahren zur Bestückung eines Werkstückes, einen Bestückungsautomaten, sowie eine Zuführeinheit für einen solchen Bestückungsautomaten.

Die automatische Bestückung von elektronischen Schaltungen (PCB's oder dergleichen) mittels Bestückungsautomaten ist seit langem bekannt. Solche Bestückungsautomaten werden insbesondere dort eingesetzt, wo komplizierte und umfangreiche Schaltungen schnell, effizient und fehlerfrei mit einer grösseren Anzahl von Bauteilen bestückt werden müssen. Die Bauteile liegen dabei nach Typen getrennt auf einzelnen Bändern vor, die auf Spulen aufgerollt sind. Die Spulen werden an einem Rüstplatz in Zuführeinheiten (Feeder) eingesetzt. Die mit Bauteilen beladenen Zuführeinheiten werden an dafür vorgesehenen Stellen in den Bestückungsautomaten eingesetzt. Im Betrieb des Bestückungsautomaten werden die Bauteile schrittweise zu einer Entnahmestelle (Pick-up Position) transportiert, wo sie der Zuführeinheit von einem Pick-up-Kopf des Bestückungsautomaten entnommen und an dem zugewiesenen Platz in der Schaltung abgesetzt werden. Derartige Bestückungsautomaten und Zuführeinheiten sind beispielsweise aus den europäischen Patentanmeldungen EP 859 543 und EP 859 544 bekannt.

Aus der WO 94/28502 ist ein Bestückungsautomat bekannt, der eine Steuereinheit aufweist, die gemäss einem zur bestückenden Schaltung gehörenden Schaltplan jeder Zuführeinheit einen bestimmten Platz am Bestückungsautomaten zuordnet. Beim Beladen der Zuführeinheiten mit neuen Bauteilen an einem Rüstplatz wird an der Zuführeinheit ein Strichcode angebracht, der die geladenen Bauteile charakterisiert. Bevor der Operateur die beladene Zuführeinheit am Bestückungsautomaten einsetzt, liest er mit einem Lesegerät deren Strichcode. Das Lesegerät übermittelt den gelesenen Code an den Bestückungsautomaten, worauf dieser aufgrund der übermittelten Daten eine LED an denjenigem Platz zum Leuchten bringt, an dem die Zuführeinheit einzusetzen ist.

Bekannt sind auch Zuführeinheiten mit einem eingebauten Mikroprozessor. Diese sind aber relativ teuer. Sollen Daten über die geladenen Bauteile im Mikroprozessor gespeichert und später an den Bestückungsautomaten übertragen werden, dann muss der Bestückungsautomat emgerichtet sein, mit den Mikroprozessoren aller Zuführeinheiten kommunizieren zu können. Dies erfordert einen hohen apparativen Aufwand auf der Seite des Bestückungsautomaten.

Der Erfindung liegt die Aufgabe zugrunde, ein kostengünstiges, einfaches Verfahren für die Bestückung von Schaltungen vorzuschlagen.

Die genannte Aufgabe wird erfindungsgemäss gelöst durch die Merkmale der Ansprüche 1, 2 und 5.

Erfindungsgemäss weist jede Zuführeinheit einen ihr eigenen, von den anderen Zuführeinheiten verschiedenen und von der ohnehin vorhandenen Kamera des Pick-up-Kopfes des Bestückungsautomaten lesbaren Code auf. Jeweils dann, wenn eine der Zuführeinheiten auf einem sogenannten Rüstplatz mit Bauteilen beladen wird, erfasst eine am Rüstplatz vorhandene Kamera automatisch den Code der Zuführeinheit. Der erfasste Code wird zusammen mit Daten, die die geladenen Bauteile identifizieren, in einer Datenbank elektronisch gespeichert. Nach dem Einsetzen der Zuführeinheit im Bestückungsautomat erfasst der Bestückungsautomat mit der ohnehin vorhandenen Kamera des Pick-up-Kopfes den Code der Zuführeinheit und entnimmt der Datenbank anhand des gelesenen Codes die Daten, die die Bauteile der zugeführten Zuführeinheit identifizieren.

Nachfolgend wird ein Ausführungsbeispiel der Erfindung anhand der Zeichnung näher erläutert.

Es zeigen:
- Fig. 1: eine Zuführeinheit und einen Bestückungsautomaten,
- Fig. 2: einen Rüstplatz, und
- Fig. 3: die Zuführeinheit in der Draufsicht.

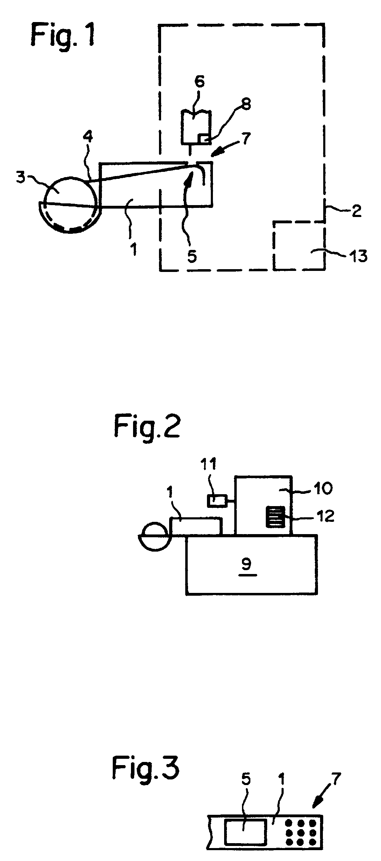

Die Fig. 1 zeigt in schematischer Darstellung eine Zuführeinheit 1 für einen Bestückungsautomaten 2, die eine Spule 3 mit einem aufgewickelten Band 4 enthält. Das Band 4 besteht aus einem Trägerband mit Taschen für die Aufnahme von Bauteilen und aus einem die Taschen verschliessenden Deckband. Der Bestückungsautomat 2 weist eine Vielzahl von Plätzen für solche Zuführeinheiten 1 auf. Im Betrieb werden die Bauteile von der Zuführeinheit 1 schrittweise zu einer Entnahmestelle 5 transportiert, wobei das Deckband an einer vor der Entnahmestelle 5 angeordneten Abziehvorrichtung vom Trägerband abgezogen wird, so dass die Bauteile für das Ergreifen mittels eines Pick-up-Kopfes 6 des Bestückungsautomaten 2 frei zugänglich sind. Die Zuführeinheit 1 weist einen neben der Entuahmestelle 5 angeordneten Code 7 auf. Der Code 7 ist einzigartig für jede der Zuführeinheiten 1, d.h. verschiedene Zuführeinheiten 1 weisen verschiedene Codes 7 auf. Der Code 7 ist so an der Zuführeinheit 1 angebracht, dass er von einer am Pick-up-Kopf 6 des Bestückungsautomaten 2 ohnehin vorhandenen Kamera 8 lesbar ist.

Die Fig. 2 zeigt einen sogenannten Rüstplatz 9. Das ist ein Ort, an dem die Zuführeinheiten 1 mit neuen Bauelementen beladen werden. Der Rüstplatz 9 weist in der Regel einen Computer 10, sowie einen Platz zur Aufnahme einer Zuführeinheit 1 auf. Der Rüstplatz 9 weist zudem eine Kamera 11 auf, die mit dem Computer 10 verbunden ist. Sobald die Zuführeinheit 1 am Rüstplatz 9 angedockt ist, erfasst die Kamera 11 den Code 7 der Zuführeinheit 1. Mittels eines auf dem Computer 10 laufenden Softwareprogrammes kann die Bedienperson, die die Zuführeinheit 1 mit den neuen Bauteilen belädt, die Bauteile charakterisierende Daten eingeben und/oder auswählen. Sobald die Daten vollständig eingegeben oder korrekt ausgewählt wurden, weist die Bedienperson den Computer 10 an, die Daten zusammen mit dem von der Kamera 11 selbsttätig ermittelten Code 7 als Datensatz in einer Datenbank 12 abzuspeichern. Sofern der Code 7 als sogenannter Primärschlüssel dient, ist sichergestellt, dass für jede der Zuführeinheiten 1 nur ein einziger Datensatz gespeichert werden kann.

Der Bestückungsautomat 2 weist ebenfalls einen Computer 13 (Fig. 1) auf, der die Bestückung von Werkstücken, beispielsweise von bedruckten Schaltungen, mit den Bauteilen steuert. Der Computer 10 des Rüstplatzes 9 ist mit dem Computer 13 des Bestückungsautomaten 2 oder, sofern in einer Fabrik mehrere Bestückungsautomaten 2 vorhanden sind, mit allen deren Computern 13 verbunden, so dass die Datenbank 12 dem bzw. allen Bestückungsautomaten 2 zugänglich ist.

Im Betrieb werden die Zuführeinheiten 1 von einer Bedienperson beim Bestückungsautomaten 2 nacheinander an den dazu vorgesehenen Plätzen eingesteckt. Sind alle Zuführeinheiten 1 eingesteckt, dann weist die Bedienperson den Computer 13 des Bestückungsautomaten 2 an, mittels des Pick-up-Kopfes 6 bzw. der daran befestigten Kamera 8 die Codes 7 aller Zuführeinheiten 1 zu lesen. Der Pick-up Kopf 6 fährt also von Zuführeinheit 1 zu Zuführeinheit 1, wobei die Kamera 8 jeweils über dem Code 7 der Zuführeinheit 1 positioniert wird. Der Computer 13 des Bestückungsautomaten 2 bestimmt dann aufgrund des Platzes, an dem jede einzelne Zuführeinheit 1 eingesteckt ist, und des von der Zuführeinheit 1 abgelesenen Codes 7, sowie der Datenbank 12, welche Zuführeinheit 1 welche Bauteile enthält.

Der Bestückungsautomat 2 ist dann in der Lage, die bedruckte Schaltung, die er mit Bauteilen bestücken soll, entsprechend deren Bestückungsplan zu bestücken.

Selbstverständlich kann während des Normalbetriebes des Bestückungsautomaten 2, in dem bedruckte Schaltungen bestückt werden, eine Zuführeinheit 1 aus ihrem Platz herausgenommen und durch eine neue Zuführeinheit 1 ersetzt werden, sei es, weil die Zuführeinheit 1 leer wurde, sei es, weil andere Bauteile zugeführt werden müssen. Die Zuführeinheit 1 ist vorzugsweise wie in der europäischen Patentanmeldung EP 859 544 beschrieben mit Signalmitteln ausgerüstet, die dem Bestückungsautomaten 2 die Herausnahme der Zuführeinheit 1 bzw. das Einstecken einer anderen Zuführeinheit 1 anzeigen. Der Bestückungsautomat 2 ist programmiert, zu einem geeigneten Zeitpunkt den Code 7 einer neu eingeführten Zuführeinheit 1 zu lesen.

Für den Code 7 kann irgendeine industrieübliche Codierung verwendet werden, Einschränkungen ergeben sich nicht hinsichtlich der Codierungsart, sondern höchstens aufgrund der engen Platzverhältnisse. Zuführeinheiten 1, die für die Verarbeitung von Bändern 4 von nur 8 Millimeter Breite vorgesehen sind, sind selbst nur wenig breiter: Der Platz für den Code 7 ist beschränkt. Aus logistischen Gründen ist es wünschenswert, dass jede Zuführeinheit einen weltweit eindeutigen Code 7 erhält, obwohl es natürlich genügt, wenn der Code 7 innerhalb einer Arbeitsumgebung bzw. innerhalb einer Fabrik eindeutig ist. Bevorzugt wird für den Code 7 deshalb nicht ein Strichcode verwendet, wie er theoretisch zwar denkbar wäre, sondern ein sogenannter Matrix Code, dessen Informationsdichte wesentlich grösser ist. Ein solcher Matrix Code ist beispielsweise der von der Organisation "Semiconductor Equipment and Materials International (SEMI)" unter der Bezeichung T9 standardisierte Code. Dieser Matrix Code besteht aus matrixartig in Reihen und Kolonnen angeordneten Punkten, wobei jeder Punkt ein Bit enthält. Mit diesem Matrix Code ist es möglich, jeder Zuführeinheit eine weltweit einzigartige Nummer zuzuweisen, die beispielsweise gleich ihrer Seriennummer ist. Die Fig. 3 zeigt die Zuführeinheit 1 in der Draufsicht, wobei als Code 7 ein solcher Matrixcode dargestellt ist, der aber aus zeichnerischen Gründen nur aus 3*3 = 9 Bits besteht. In der Zeichnung bedeutet ein schwarzer Punkt ein Bit 1, ein nicht vorhandener Punkt, dargestellt als Kreis, bedeutet ein Bit 0.

Die Daten, die in einem Datensatz der Datenbank 12 gespeichert sind, können neben den für die Bestückung unmittelbar benötigten Daten wie z.B. Typ des Bauteils (Widerstand, Kondensator, etc.), dessen physikalischem Wert (10 Ohm, 100 Ohm, etc.) auch weitere Angaben enthalten, z.B. die Anzahl der in der Zuführeinheit 1 vorhandenen Bauteile. Dies ermöglicht es dem Bestückungsautomaten 2, über die Anzahl der in den Zuführeinheiten 1 noch vorhandenen Bauteile genau Buch zu führen, und z.B. einen akustischen oder visuellen Alarm auszulösen, wenn die Bauteile einer Zuführeinheit 1 zur Neige gehen oder bereits zur Neige gegangen sind.

Es ist auch möglich, dass das Band einer der Zuführeinheiten 1 gleiche Bauteile aus verschiedenen Losen oder zuerst Bauteile eines ersten Typs und dann Bauteile eines zweiten Typs enthält. Solche Zuführeinheiten können vom Bestückungsautomaten problemlos bearbeitet werden. Es ist nur nötig, diese Information in der Datenbank in geeigneter Form zu speichern.

Die Vorteile der Erfindung sind darin zu sehen, dass die Daten über die in den Zuführeinheiten enthaltenen Bauteile weder mit einem Strichcode auf der Zuführeinheit noch elektronisch in einem in die Zuführeinheit eingebauten Datenspeicher gespeichert und mit entsprechendem Aufwand gelesen werden müssen. Bestehende Bestückungsautomaten lassen sich über ein Softwareupdate nachrüsten. Bestehende Zuführeinheiten lassen sich problemlos weiterverwenden, sie müssen nur mit dem individuellen Code versehen werden.

Das erfindungsgemässe Verfahren weist weiter den Vorteil auf, dass sich der Materialfluss vollautomatisch in elektronischer Form verfolgen und für spätere Zwecke speichern lässt. Damit lässt sich z.B. dann, wenn bei einer bestückten Schaltung infolge eines schadhaften Bauteils ein Fehler auftritt, genau eruieren, aus welchem Los bzw. von welchem Lieferant das fehlerhafte Bauteil stammte.

## Patentansprüche

1. Verfahren zur Bestückung eines Werkstückes mit Bauteilen, bei dem die Bauteile in Zuführeinheiten (1) bereitgestellt werden, die in einen Bestückungsautomaten (2) einsetzbar sind, und bei dem die Bauteile entsprechend einem zum Werkstück gehörigen Bestückungsplan von einem Pick-up-Kopf des Bestückungsautomaten (2) einer Entnahmestelle (5) der jeweiligen Zuführeinheit (1) entnommen und auf dem Werkstück plaziert werden, wobei der Pick-up-Kopf (6) eine Kamera (8) aufweist und wobei die Zuführeinheiten (1) jeweils an einem Rüstplatz (9) mit neuen Bauteilen beladen werden,
**dadurch gekennzeichnet, dass**
jede der Zuführeinheiten (1) einen ihr eigenen, von den anderen Zuführeinheiten (1) verschiedenen und von der Kamera (8) des Pick-up-Kopfes (6) lesbaren Code (7) aufweist,
dass jeweils dann, wenn eine der Zuführeinheiten (1) auf dem Rüstplatz (9) mit Bauteilen beladen wird, der Code (7) der Zuführeinheit (1) von einer am Rüstplatz (9) vorhandenen Kamera (11) automatisch erfasst und mit Daten, die die geladenen Bauteile identifizieren, in einer Datenbank (12) gespeichert wird,
dass der Bestückungsautomat (2) nach dem Einsetzen einer Zuführeinheit (1) mit der Kamen (8) des Pick-up-Kopfes (6) den Code (7) der Zuführeinheit (1) erfasst und
dass der Bestückungsautomat (2) die Daten, die die Bauteile der zugeführten Zuführeinheit (1) identifizieren, anhand des Codes (7) der Zuführeinheit (1) aus der Datenbank (12) entnimmt.

2. Zuführeinheit (1) für die Zuführung von Bauteilen zu einem Bestückungsautomaten (2), wobei die Bauteile schrittweise zu einer Entnahmestelle (5) transportierbar sind, **dadurch gekennzeichnet, dass** die Zuführeinheit (1) mit einem Code (7) versehen ist, der von einer von einem Pick-up-Kopf (6) des Bestückungsautomaten (2) mitgeführten Kamera (8) lesbar ist.

3. Zuführeinheit (1) nach Anspruch 2, **dadurch gekennzeichnet, dass** der Code (7) aus matrixartig in Reihen und Kolonnen angeordneten Codeelementen besteht.

4. Zuführeinheit (1) nach Anspruch 2 oder 3, **dadurch gekennzeichnet, dass** der Code (7) neben der Entnahmestelle (5) angeordnet ist.

5. Bestückungsautomat (2), bei dem mehrere Zuführeinheiten (1) an dafür vorgesehenen Stellen einsetzbar sind, mit einer an einem Pick-up-Kopf (6) montierten Kamera (8), **dadurch gekennzeichnet, dass** der Bestückungsautomat (2) eingerichtet ist, mit der Kamera (8) einen auf den Zuführeinheiten (1) angebrachten Code (7) zu lesen und dass der Bestückungsautomat (2) auf eine Datenbank (12) zugreifen kann, in der die Daten der Bauteile der eingesetzten Zuführeinheiten (1) zusammen mit dem entsprechenden Code (7) der Zuführeinheit (1) gespeichert sind.
